# EUROPEAN PATENT APPLICATION

(11) **EP 4 383 287 A1**
(43) Date of publication of application: **12.06.2024**
(21) Application number: 22853569.6
(22) Date of filing: 05.08.2022
(51) Int. Cl.: H01F 27/33, H01F 27/28, H01F 27/29, H03H 7/01

(54) **COMPOSITE ELEMENT**

(30) Priority: 06.08.2021 KR 20210104071
(71) Applicant: Moda-Innochips Co., Ltd., Ansan-si, Gyeonggi-do 15433 (KR)
(72) Inventor: LEE, Myung Ho, Ansan-si, Gyeonggi-do 15502 (KR)
(74) Representative: Michalski Hüttermann & Partner Patentanwälte mbB
(86) International application number: PCT/KR2022/011721
(87) International publication number: WO 2023/014194

(57) **Abstract**

The present invention relates to a composite element, which includes a stacked body in which a plurality of sheets are stacked, a plurality of first noise filter portions capable of generating a first resonance frequency and provided in the stacked body, each first noise filter portion including one or more coil patterns, a second noise filter portion capable of generating a second resonance frequency higher than the first resonance frequency, provided in the stacked body, and including a capacitor and an inductor, a plurality of external electrodes provided outside the stacked body and connected to the plurality of first noise filter portions and a part of the second noise filter portion, and a ground electrode provided outside the stacked body and connected to a part of the second noise filter portion, and can expand the band of frequencies at which noise can be removed and adjust the resonant frequency for removing noise.

## Description

### TECHNICAL FIELD

The present invention relates to a composite element, and more specifically, to a composite element that can remove noise in a wideband frequency.

### BACKGROUND ART

Recently, various frequency bands are being used as a portable electronic device, such as a smartphone, becomes more multi-functional. That is, a plurality of functions using different frequency bands, such as wireless LAN, Bluetooth, and GPS, have been adopted within one smartphone. Further, as an electronic device becomes more highly integrated, the density of internal circuits in a limited space increases, and as a result, noise interference inevitably occurs between the internal circuits. For example, noise in a frequency of 750 MHz degrades smartphone call quality, and noise in a frequency of 1.5 GHz degrades GPS quality. In this way, the composite element is being used to suppress noise of various frequencies in the portable electronic device. For example, a condenser, a chip bead, a common mode filter, etc. that remove noise in different frequency bands are used.

However, such a composite element has a narrow frequency band at which noise can be removed, which makes it difficult to apply the composite element to an electronic device that uses frequencies in a relatively wideband frequency.

Prior art document 1: KR10-2019-0140576 A

### DISCLOSURE OF THE INVENTION

### TECHNICAL PROBLEM

The present invention provides a composite element that can remove noise in a wideband frequency.

### TECHNICAL SOLUTION

A composite element according to an embodiment of the present invention includes a stacked body in which a plurality of sheets are stacked, a plurality of first noise filter portions capable of generating a first resonance frequency and provided in the stacked body, each first noise filter portion including one or more coil patterns, a second noise filter portion capable of generating a second resonance frequency higher than the first resonance frequency, provided in the stacked body, and including a capacitor and an inductor, a plurality of external electrodes provided outside the stacked body and connected to the plurality of first noise filter portions and a part of the second noise filter portion, and a ground electrode provided outside the stacked body and connected to a part of the second noise filter portion.

The plurality of first noise filter portions may include at least three or more noise filter portions.

The coil patterns forming the plurality of first noise filter portions may be respectively formed on different sheets, and may be disposed to overlap each other in a direction crossing a stacking direction.

The coil patterns forming the plurality of first noise filter portions may be respectively formed on different sheets, and at least one of the coil patterns may be disposed to partially overlap or be spaced apart from the remaining coil patterns in a direction crossing a stacking direction.

The second noise filter portion may be formed on a sheet different from the plurality of first noise filter portions.

The capacitor may include internal electrodes respectively connected to the plurality of external electrodes and at least one common electrode disposed to overlap the internal electrodes, and the inductor may be connected to the ground electrode.

The capacitor and the inductor may be formed on different sheets, and the second noise filter portion may include a via electrode for connecting the common electrode and the inductor.

The second noise filter portion may include a plurality of inductors formed on different sheets, and the plurality of inductors may be connected to one via electrode.

The common electrode may be provided in plural numbers, and the via electrode may be provided in the same number as the common electrode.

The second noise filter portion may include a plurality of inductors formed on one sheet, each of the plurality of inductors may be connected to a different via electrode, and the plurality of inductors may be connected to each other by a horizontal connection wiring.

The second noise filter portion may include a plurality of inductors formed on different sheets, and each of the plurality of inductors may be connected to a different via electrode.

A width between the first resonance frequency and the second resonance frequency may be adjusted by at least one of a capacitance of the capacitor and an inductance of the inductor, and an impedance formed between the coil patterns.

### ADVANTAGEOUS EFFECTS

According to the embodiment of the present invention, it is possible to implement the composite element that can expand the band of frequencies at which noise can be removed and can adjust a resonant frequency to remove noise. That is, the composite element may include a first noise filter portion capable of removing noise in a specific frequency band, and a second noise filter capable of removing noise in a frequency band different from the first noise filter portion. Accordingly, the composite element can expand the band of frequencies at which noise can be removed, and thus noise in a wideband frequency can be removed. Further, the resonance frequency can be finely adjusted by the interaction between the first noise filter and the second noise filter. Accordingly, the composite element can be used in the portable electronic device that uses a wide frequency band to improve quality of the electronic device.

### BRIEF DESCRIPTION OF THE DRAWINGS

FIG. 1 is a perspective view of a composite element according to an embodiment of the present invention.
FIG. 2 is a cross-sectional view of the composite element taken along line A-A' illustrated in FIG. 1.
FIG. 3 is an exploded perspective view of the composite element according to the embodiment of the present invention.
FIG. 4 is an equivalent circuit diagram of the composite element according to an embodiment of the present invention.
FIGS. 5 to 7 are diagrams illustrating modified examples of the composite element according to the embodiment of the present invention.
FIG. 8 is a graph of the frequency characteristics of the composite element according to the embodiment of the present invention.

### MODE FOR CARRYING OUT THE INVENTION

Hereinafter, embodiments of the present invention will be described in detail with reference to the accompanying drawings. However, the present invention is not limited to the embodiments disclosed below, but will be implemented in a variety of different forms, and these embodiments are provided only to complete the disclosure of the present invention and to fully inform those skilled in the art of the scope of the invention. In the drawing, the thickness is enlarged and expressed in order to clearly express various layers and each region, and in the drawing, the same reference sign refers to the same element.

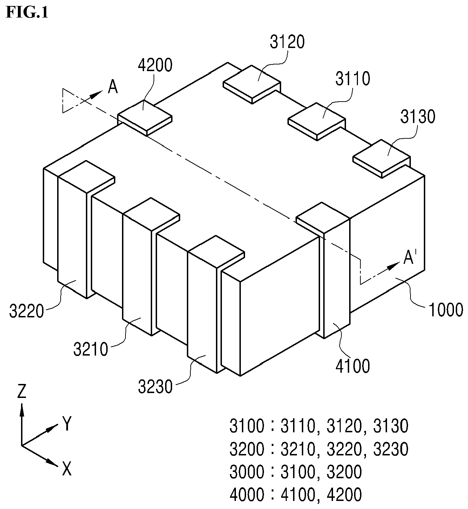

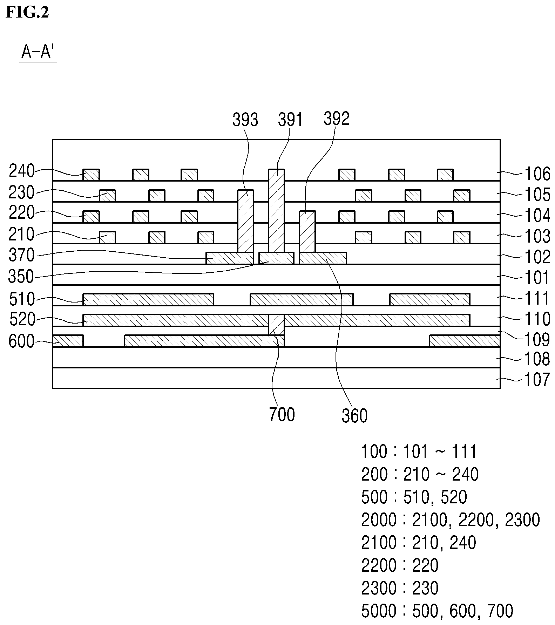

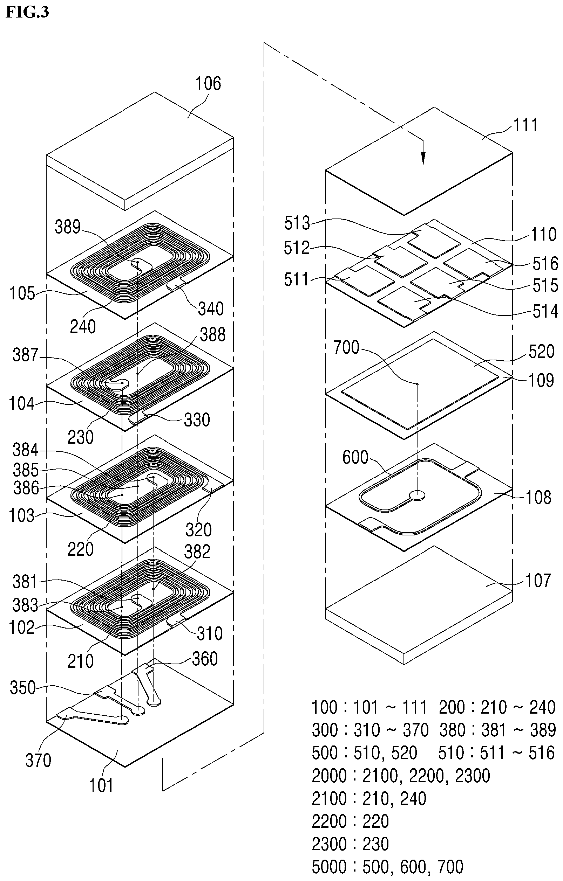

FIG. 1 is a perspective view of a composite element according to an embodiment of the present invention, FIG. 2 is a cross-sectional view of the composite element taken along line A-A' illustrated in FIG. 1, and FIG. 3 is an exploded perspective view of the composite element according to the embodiment of the present invention.

Referring to FIGS. 1 to 3, the composite element according to an embodiment of the present invention may include a stacked body 1000 in which a plurality of sheets are stacked, and a plurality of first noise filter portions 2000 capable of generating a first resonant frequency and provided within the stacked body 1000, each first noise filter portion including one or more coil patterns 200 , a second noise filter portion 5000 capable of generating a second resonance frequency higher than the first resonance frequency, provided in the stacked body 1000, and including a capacitor 500 and an inductor 600, a plurality of external electrodes 3000 provided outside the stacked body and connected to a plurality of first noise filter portions 2000 and a part of the second noise filter portion 5000, and ground electrodes 4000 (4100, 4200) provided outside the stacked body 1000 and connected to a part of the second noise filter portion 5000.

The stacked body 1000 may be provided in an approximately hexahedral shape. That is, the stacked body 1000 may be provided in an approximately hexahedral shape having a predetermined length and width in one direction (e.g., X-direction) and the other direction (e.g., Y-direction) orthogonal to each other in the horizontal direction, and a predetermined height in the vertical direction (e.g., Z-direction). Here, the length in the X-direction may be the same as or different from the width in the Y-direction, and the width in the Y-direction may be the same as or different from the height in the Z-direction. The size of the stacked body 1000 in the X-, Y-, and Z-directions can be varied in various ways depending on an internal structure of an electronic device to which the composite element is connected, a shape of the composite element, etc.

The stacked body 1000 may be formed by stacking a plurality of sheets 100 (101 to 111). That is, the stacked body 1000 may be formed by stacking the plurality of sheets 100 having a predetermined length in the X-direction, a predetermined width in the Y-direction, and a predetermined thickness in the Z-direction. Accordingly, the length and width of the stacked body 1000 may be determined by the length and width of the sheets 100, and the height of the stacked body 1000 may be determined by the number of sheets 100 stacked. Meanwhile, the plurality of sheets 100 may be magnetic sheets or non-magnetic sheets. That is, the plurality of sheets 100 may all be magnetic sheets or non-magnetic sheets. However, at least some of the plurality of sheets 100 may be magnetic sheets, and the remainder thereof may be non-magnetic sheets.

The plurality of sheets 100 may be provided in a rectangular plate shape having a predetermined thickness. For example, the plurality of sheets 100 may be provided in a square plate shape having the same length and width, or may be provided in a rectangular plate shape having different lengths and widths. Further, the plurality of sheets 100 may all be formed to have the same thickness, and at least one of the plurality of sheets 100 may be formed to be thicker or thinner than the others.

Further, the stacked body 1000 may further include a cover layer (not illustrated) provided on at least one of the lower part and upper part. That is, the stacked body 1000 may include cover layers respectively provided on the lowest layer and the uppermost layer. In this case, only one cover layer may be provided at the upper part or lower part, or may be provided at both the upper part or lower part. Of course, the lowest layer sheet, i.e., the seventh sheet 107, may function as a lower cover layer without being provided with a separate cover layer, and the uppermost sheet, i.e., the sixth sheet 106 may function as an upper cover layer. The material of the stacked body 1000 may be LTCC or ferrite, and the two materials may be applied together. For example, the sixth sheet 106 and the seventh sheet 107 may be ferrite, and the remaining sheets 101 to 105 and 108 to 111 may be low temperature co-fired ceramic (LTCC), and ferrite may be added to the upper part of the sixth sheet 106 or the lower part of the seventh sheet 107. The thickness of each sheet 100 may be 10 to 200 µm or 15 to 100 µm.

The first noise filter portion 2000 may include a plurality of noise filter portions, for example, a 1-1 st noise filter portion 2100, a 1-2nd noise filter portion 2200, and a 1-3rd noise filter portion 2300. The 1-1st to 1-3rd noise filter portions 2100, 2200, and 2300 may be formed by one or two coil patterns 200 connected in the vertical direction. The three first noise filter portions 2000 (2100, 2200, 2300) may be formed in the vertical direction (Z-direction), that is, in the stacking direction of the sheets 100. Here, the first noise filter portion 2000 may include a common mode noise filter that removes common mode noise. Further, at least three first noise filter portions 2000 are connected to external electrodes 3000 outside the stacked body 1000, for example, a first external electrode 3100 and a second external electrode 3200. This first noise filter portion 2000 may generate a first resonance frequency capable of removing noise of a frequency within the composite element. For example, the first noise filter portion 2000 may generate the first resonance frequency in the 1.5 to 3 GHz band.

Hereinafter, an example of the first noise filter portion 2000 will be described with reference to FIGS. 2 and 3.

The first noise filter portion 2000 may include a plurality of coil patterns 200 (210 to 240) selectively formed on the plurality of sheets 100, first lead-out electrodes 310 to 340 drawn out from the coil pattern 200 to be exposed to the outside of the sheet 100, second lead-out electrodes 350 to 370 formed on a different sheet from the coil pattern 200, and vertical connection wirings 391 to 393 that connect the plurality of coil patterns 200 and the second lead-out electrodes 350 to 370 in the vertical direction, and consist of holes 380 (381 to 389) filled with a conductive material. That is, the coil patterns 200 (210 to 240) are respectively formed on the upper part of the plurality of sheets 100, and in the stacking direction of the sheet 100, that is, in the vertical direction, the coil patterns 200 and the second lead-out electrodes 350 to 370 are connected by the holes 380 (381 to 389) filled with a conductive material, that is, the vertical connection wirings 391 to 393. In this case, at least two or more of the plurality of coil patterns 200 (210 to 240) may be connected to one of the second lead-out electrodes 350 to 370 350 to 370 by the vertical connection wirings 391 to 393.

The first sheet 101 is formed with three second lead-out electrodes 350 to 370 respectively connected to the three first noise filter portions 2000. The second lead-out electrodes 350 to 370 may include a 2-1st lead-out electrode 350, a 2-2nd lead-out electrode 360, and a 2-3rd lead-out electrode 370. The 2-1st lead-out electrode 350, the 2-2nd lead-out electrode 360, and the 2-3rd lead-out electrode 370 may be formed to be connected to the second external electrode 3200. For example, the 2-1st lead-out electrode 350 may be connected to a 2-1st external electrode 3210, the 2-2nd lead-out electrode 360 mat be connected to a 2-2nd external electrode 3220, and the 2-3rd lead-out electrode 370 may be connected to a 2-3rd external electrode 3230. The second lead-out electrodes 350 to 370 may be formed to have a width wider than the width of the coil pattern 200, and may preferably be formed to have a width narrower than or equal to the width of the external electrode 3000. By forming the width of the second lead-out electrodes 350 to 370 to be wider than the width of the coil pattern 200, a contact area with the external electrode 3000 can be increased, thereby capable of reducing the contact resistance between the second lead-out electrodes 350 to 370 and the external electrode 3000.

On the second sheet 102, the first coil pattern 210, the plurality of holes 381, 382, and 383, which are filled with a conductive material and spaced apart from each other, and the 1-1 st lead-out electrode 310 are formed. On the third sheet 103 provided on an upper side of the second sheet 102, the second coil pattern 220, the plurality of holes 384, 385, and 386, which are filled with a conductive material and spaced apart from each other, and the 1-2 lead-out electrodes 320 are formed. On the fourth sheet 104 provided on the upper side of the third sheet 103, the third coil pattern 230, the plurality of holes 387 and 388, which are filled with a conductive material and spaced apart from each other, and the 1-3rd lead-out electrodes 330 are formed. On the fifth sheet 105 provided on the upper side of the third sheet 104, the fourth coil pattern 240, the hole 389 filled with a conductive material, and the 1-4th lead-out electrodes 340 are formed.

Each of the first to fourth coil patterns 200 (210 to 240) may be formed with a predetermined number of turns by rotating in one direction from the central area of each of the second to fifth sheets 102 to 105. The first coil pattern 210 may be formed by rotating in one direction from an area corresponding to the hole 381 of the second sheet 102, and the second coil pattern 220 may be formed by being spaced apart from the hole 381 by a predetermined spacing and rotating in one direction from an area corresponding to the hole 382 of the second sheet 102. Further, the third coil pattern 230 may be formed by being spaced apart from the hole 381 of the second sheet 102 by a predetermined spacing and rotating in one direction from an area corresponding to the hole 383 of the second sheet 102. The fourth coil pattern 240 may be formed by rotating in one direction from the area corresponding to the hole 381 of the second sheet 102. Among these first to fourth coil patterns 210 to 240, at least the first coil pattern 210 and the fourth coil pattern 240 may be formed to overlap each other in the stacking direction.

Further, the coil pattern 200 may be formed to have a predetermined number of turns, and the numbers of turns of the coil patterns 200 may all be the same or at least one number of turns may be different. The coil pattern 200 has a predetermined line width and spacing and may be formed in a spiral shape that rotates outward in at least one of counterclockwise and clockwise directions. The impedance of the coil pattern 200 may be adjusted depending on the line width and spacing. That is, as the line width of the coil pattern 200 becomes narrower, the impedance increases, and as the line width becomes wider, the impedance decreases. Further, as the spacing between the coil patterns 200 becomes narrower, the impedance decreases, and as the spacing becomes wider, the impedance increases.

Meanwhile, the coil pattern 200 may be connected to the first lead-out electrodes 310 to 340 drawn outward from the sheet 100 and the second lead-out electrodes 350 to 370 formed on the first sheet 101. The 1-1st lead-out electrode 310 connected to the first coil pattern 210 is formed to be exposed to a predetermined area on one long side of the second sheet 102. The 1-2nd lead-out electrode 320 connected to the second coil pattern 220 is formed to be exposed to one long side of the third sheet 103 and is formed to be spaced apart from the 1-1st lead-out electrode 310. The 1-3rd lead-out electrode 330 connected to the third coil pattern 230 is formed to be exposed to one long side of the fourth sheet 104 and is formed spaced apart from the 1-1st and 1-2nd lead-out electrodes 310 and 320. The 1-4th lead-out electrode 340 connected to the fourth coil pattern 240 is formed to be exposed to one long side of the fifth sheet 105, is formed to be exposed to the area corresponding to the 1-1st lead-out electrode 310, and is formed to overlap the 1-1st lead-out electrode 310.

The first lead-out electrodes 310 to 340 are formed to have a width wider than the width of the coil pattern 200, and may preferably be formed to have a width narrower than or equal to the width of the external electrode 3000. By forming the width of the first lead-out electrodes 310 to 340 to be wider than the width of the coil pattern 200, the contact area with the external electrode 3000 can be increased, thereby capable of reducing the contact resistance between the first lead-out electrodes 310 to 340 and the external electrode 3000.

The first coil pattern 210, the fourth coil pattern 240, and the 2-1 lead-out electrode 350 may be connected by the first vertical connection wiring 391 to form the 1-1st noise filter portion 2100. In this case, the first vertical connection wiring 391 is formed by the holes 381, 385, 388, and 389 which are filled with conductive material and respectively formed in the second sheet 102, third sheet 103, fourth sheet 104, and fifth sheet 105. The second coil pattern 220 and the 2-2nd lead-out electrode 360 may be connected by the second vertical connection wiring 392 to form the 1-2nd noise filter portion 2200. In this case, the second vertical connection wiring 392 is formed by the holes 382 and 384 which are filled with a conductive material and respectively formed in the second sheet 102 and the third sheet 103. Further, the third coil pattern 230 and the 2-3rd lead-out electrode 370 may be connected by the third vertical connection wiring 393 to form the 1-3rd noise filter portion 2300. In this case, the third vertical connection wiring 393 is formed by the holes 383, 386, and 387 which are filled with the conductive material and respectively formed in the second sheet 102, the third sheet 103, and the fourth sheet 104. However, the connection method of coil patterns spaced apart from each other can be modified in various ways.

Further, the 1-1st lead-out electrode 310 and the 1-4th lead-out electrode 340 respectively connected to the first coil pattern 210 and the fourth coil pattern 240 are connected to the 1-1st external electrode 3110, and the 2-1st lead-out electrode 350 is connected to the 2-1st external electrode 3210. The 1-2nd lead-out electrode 320 connected to the second coil pattern 220 is connected to the 1-2nd external electrode 3120, and the 2-2nd lead-out electrode 360 is connected to the 2-2nd external electrode 3220. The 1-3rd lead-out electrode 330 connected to the third coil pattern 230 is connected to the 1-3rd external electrode 3130, and the 2-3rd lead-out electrode 370 is connected to the 2-3rd external electrode 3230. Accordingly, the 1-1st noise filter portion 2100 is connected between the 1-1st and 2-1st external electrodes 3110 and 3210, the 1-2nd noise filter portion 2200 is connected between the 1-2nd and 2-2nd external electrodes 3120 and 3220, and the 1-3rd noise filter portion 2300 is connected between the 1-3rd and 2-3rd external electrodes 3130 and 3230.

Meanwhile, the numbers of turns of the coil patterns 200 that respectively form the 1-1st to 1-3rd noise filter portions 2100, 2200, and 2300 may be the same or may be different. As the numbers of turns of the coil patterns 200 forming the first noise filter portion 2000 are different, one composite element may have at least two or more impedance characteristics. Further, the coil pattern 200, the first lead-out electrodes 310 to 340, and the second lead-out electrodes 350 to 370 respectively formed on the plurality of sheets 100 according to the embodiment of the present invention may be formed of a conductive material such as metal. Here, the coil pattern 200, the first lead-out electrodes 310 to 340, and the second lead-out electrodes 350 to 370 may be formed through a plating process, a printing process, and may be formed through a deposition process, etc.

Here, the first noise filter portion 2000 is described as being formed of four coil patterns 200, but the first noise filter portion 2000 may be formed of three or five or more coil patterns. Further, the first noise filter portion 2000 may include three or more noise filter portions in which two or more coil patterns are connected by the vertical connection wiring. Further, the second lead-out electrodes 350 to 370 may be respectively formed on the sheet on which the coil pattern is formed. Further, in FIGS. 2 and 3, it is illustrated that the coil patterns 200 are disposed to overlap each other in the horizontal direction (X- or Y-direction), but at least one of the coil patterns 200 may be disposed to partially overlap or be spaced apart from the remaining coil patterns 200 in the horizontal direction. However, the number, the formation positions, etc. of the coil patterns 200 of the first noise filter portion 2000, the formation method, etc. of the second lead-out electrodes 350 to 370 are not limited thereto, and may be changed in various ways.

The second noise filter portion 5000 may include a capacitor 500 and an inductor 600 formed to be spaced apart from the first noise filter portion 2000 in the vertical direction (Z-direction). The second noise filter portion 5000 may be formed on a different sheet from the first noise filter portion 2000, and may be formed to be spaced apart from the first noise filter portion 2000 in the stacking direction. This second noise filter portion 5000 may generate a second resonant frequency in a higher frequency band than the frequency band that the first noise filter portion 2000 can remove within the composite element by the capacitance of the capacitor 500 and the inductance of the inductor 600. For example, the second noise filter portion 5000 may generate the second resonance frequency in a frequency band exceeding 3 GHz or between 4 GHz and 7 GHz.

The second noise filter portion 5000 may generate the second resonance frequency at which noise can be removed by using a resonance effect between the capacitance of the capacitor 500 and the inductance of the inductor 600. This second noise filter portion 5000 may generate the second resonance frequency having a higher frequency value than the first resonance frequency generated by the first noise filter portion, and may remove noise of the frequency in a frequency band higher than the first noise filter portion 2000. For example, the first noise filter portion 2000 may generate a first resonant frequency in the 1.5 to 3 GHz band and remove noise of the frequency in the corresponding frequency band. On the other hand, the second noise filter portion 5000 may generate a second resonant frequency in the 4 to 7 GHz band, which is higher than the 3 GHz band, and remove noise of the frequency in the corresponding frequency band. Further, the second noise filter portion 5000 may adjust the second resonance frequency value by adjusting a capacitance value and an inductance value. For example, when the capacitance value and the inductance value increase, the generated second resonance frequency value decreases, and thus, the second noise filter unit 5000 may remove noise in a relatively low frequency band. Further, when the capacitance value and inductance value decrease, the generated second resonance frequency value increases, and thus, the second noise filter unit 5000 may remove noise in a relatively high frequency band. On the other hand, the first resonance frequency value is adjusted by the impedance of the first noise filter portion 2000, and is not significantly affected by changes in the capacitance and inductance values of the second noise filter portion 5000. That is, in terms of frequency characteristics, the first noise filter portion 2000 and the second noise filter portion 5000 are slightly influenced by each other, but the characteristics are controlled almost independently. In this way, the second noise filter portion 5000 can remove noise in a different frequency band than that of the first noise filter portion 2000, and can adjust the frequency band for removing noise by the resonance effect of capacitance and inductance.

Hereinafter, an example of the second noise filter portion 5000 will be described with reference to FIGS. 2 and 3.

Referring to FIGS. 2 and 3, the second noise filter portion 5000 may include an internal electrode 510 and a common electrode 520 provided in the stacked body 1000, formed on different sheets 100, and provided so that at least a part of them overlap each other. For example, the internal electrode 510 and the common electrode 520 of a predetermined shape are respectively provided on the ninth sheet 109 and the tenth sheet 110, and the internal electrode 510 and the common electrode 520 may be disposed so that at least a part of the internal electrode 510 and the common electrode 520 overlap each other. In this case, an eleventh sheet 111 may be provided on the tenth sheet 110 in order to protect the internal electrode 510. The internal electrode 510 may be provided in plural numbers and may be connected to at least one of the first and second external electrodes 3100 and 3200 respectively formed on two opposing side surfaces of the stacked body 1000. For example, on the tenth sheet 110, a first internal electrode 511, a second internal electrode 512, a third internal electrode 513, a fourth internal electrode 514, a fifth internal electrode 515, and a sixth internal electrode 516 are provided, and each of the first to sixth internal electrodes 511 to 516 is connected to the 1-1st to 2-3rd external electrodes 3000. In this case, the first to third internal electrodes 511 to 513 may be provided to be spaced apart from each other on one side of the tenth sheet 110 and connected to the second external electrode 3200, and the fourth to sixth internal electrodes 514 to 516 may be provided to be spaced apart from each other on the other side of the tenth sheet 110 and may be connected to the first external electrode 3100. The common electrode 520 may be provided to overlap at least a part of the first to sixth internal electrodes 511 to 516 on the ninth sheet 109. Further, on the ninth sheet 109, a via electrode 700 formed of a conductive material in order to connect the common electrode 520 and the inductor 600 may be formed.

The inductor 600 may be provided on a different sheet from the capacitor 500, and may be connected to the common electrode 520 of the capacitor 500 through the via electrode 700. For example, the inductor 600 may be provided on the eighth sheet 108 to be connected to the via electrode 700, and may be formed to be exposed to at least one short side of the eighth sheet 108 to be connected to the ground electrode 4000. The inductor 600 may be connected to two ground electrodes 4000, or may be connected to only one of the two ground electrodes 4000. The inductor 600 may have a predetermined line width and spacing and may be formed as a straight line, a curve, or and a linear shape in which the straight line and the curved line are mixed. This inductor 600 may form inductance together with the via electrode 700. Further, the inductor 600 may adjust the inductance value depending on the length and line width. That is, the inductance value of the inductor 600 increases as the length becomes longer, and the inductance value decreases as the length becomes shorter. Further, the inductance value of the inductor 600 decreases as the line width becomes wider, and the inductance value increases as the line width decreases.

The external electrodes may be formed on two opposing side surfaces of the stacked body 1000 and connected to at least three first noise filter portions 200 and a part of the second noise filter portion 5000. Three external electrodes 3000 may be provided on each of two sides of the stacked body 1000. That is, two external electrodes 3000 may be formed on each of two sides of the three first noise filter portions 2100, 2200, and 2300, respectively. In this case, the external electrodes 3110, 3120, and 3130 formed on one side of the stacked body 1000 are referred to as the first external electrode 3100, and the external electrodes 3210, 3220, and 3230 formed on the other side are referred to as the second external electrode 3200. These external electrodes 3000 are connected to the first to third noise filters 2100, 2200, and 2300 and the internal electrode 510 forming the capacitor 500 of the second noise filter portion 5000 inside the stacked body 1000, and may be connected to one terminal and the other terminal, for example, a signal input terminal and a signal output terminal, outside the stacked body 1000.

The ground electrode 4000 may be spaced apart from the external electrode 3000, may be formed on two opposing side surfaces of the stacked body 1000, and may be connected to a part of the second noise filter portion 5000. The ground electrode 4000 may be formed on a side of the stacked body 1000 on which the external electrode 3000 is not formed. For example, the first and second external electrodes 3100 and 3200 are formed on two opposing side surfaces in the Y-direction of the stacked body 1000, and the ground electrode 4000 may be formed on two opposing side surfaces in the X-direction of the stacked body 1000. This ground electrode 4000 may be connected to the inductor 600 of the second noise filter portion 5000.

The external electrode 3000 and the ground electrode 4000 may be formed to extend to the upper surface and lower surface of the stacked body 1000. That is, the external electrode 3000 and the ground electrode 4000 may be formed to extend to two opposing surfaces of the stacked body 1000 in the Z-direction, that is, the upper surface and the lower surface. Accordingly, the external electrode 3000 and the ground electrode 4000 may be formed to extend from the side surface of the stacked body 1000 to the upper surface and the lower surface, and may be formed in a "c" shape, for example. Of course, the external electrode 3000 and the ground electrode 4000 may be formed on a side surface of the stacked body 1000 and a surface on which the composite element of the present invention is mounted, for example, a lower surface, and may be formed in an "L" shape, for example. That is, the external electrode 3000 and the ground electrode 4000 may not be formed to extend to an upper surface of the stack 1000, but may be formed to extend to the side surface and lower surface of the stack 1000.

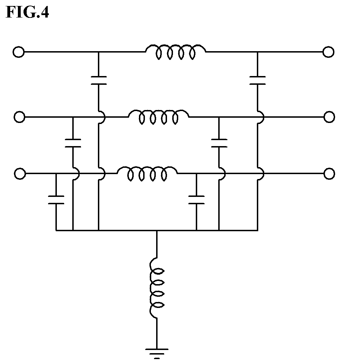

FIG. 4 is an equivalent circuit diagram of a stacked device according to the embodiment of the present invention.

Referring to FIG. 4, in the stacked device according to the embodiment of the present invention, three coil patterns are provided in parallel between the external electrodes 3000 to form three first noise filter portions 2000. Also, two capacitors 500 are provided with each of the three coil patterns in between and one inductor 600 is provided between the capacitor 500 and the ground electrode 4000, thereby forming the second noise filter portion 5000. In this case, the first noise filter portion 2000 and the capacitor 500 are connected to the external electrodes 3000, and the inductor 600 is connected to the six capacitors 500 and the ground electrode 4000. As such, the stacked device according to the embodiment of the present invention may include, within the stacked body 1000, the first noise filter portion 2000 formed in a coil pattern and the second noise filter portion 5000 formed with the capacitor 500 and the inductor 600.

In the stacked device, a signal input to the external electrode 3000 passes through the coil pattern, that is, the first noise filter portion 2000 and the second noise filter portion 5000 and common mode noise in the low frequency band included in the signal can be removed by the first noise filter portion 2000, and and common mode noise in the high frequency band included in the signal can be removed by the second noise filter portion 5000.

As such, by using the first noise filter portion 2000 including the coil pattern 200 and the second noise filter portion including the capacitor 500 and the inductor 600, at least one of impedance, inductance, and capacitance can be adjusted within the composite element, and, accordingly, the first resonance frequency value and the second resonance frequency value can be adjusted. For example, when the impedance of the first noise filter portion 2000 is adjusted, the first resonance frequency value can be adjusted. Further, when the capacitance value and inductance value of the second noise filter portion 5000 are adjusted, the second resonance frequency value can be adjusted. For example, when the capacitance value and the inductance value of the second noise filter portion 5000 are increased, the generated second resonance frequency value decreases, thereby capable of removing noise in a relatively low frequency band. Further, when the capacitance value and the inductance value of the second noise filter portion 5000 are decreased, the generated second resonance frequency value increases, thereby capable of removing noise in a relatively high frequency band. On the other hand, the first resonance frequency value is adjusted by the impedance of the first noise filter portion 2000, and is not significantly affected by changes in the capacitance and inductance values of the second noise filter portion 5000. That is, although the first noise filter portion 2000 and the second noise filter portion 5000 are slightly affected by each other in terms of frequency characteristics, the characteristics of the first noise filter portion 2000 and the second noise filter portion 5000 are controlled almost independently. Accordingly, by adjusting the first resonance frequency value and the second resonance frequency value generated by the two types of noise filter portions, the stacked device according to the embodiment of the present invention can suppress noise in two or more frequency bands and and expand the frequency band in which noise can be removed. Accordingly, the stacked device according to the embodiment of the present invention can be used in the portable electronic device such as a smartphone that employs functions of various frequencies to improve the quality of the electronic device.

Meanwhile, the second noise filter portion 5000 can be modified into various forms.

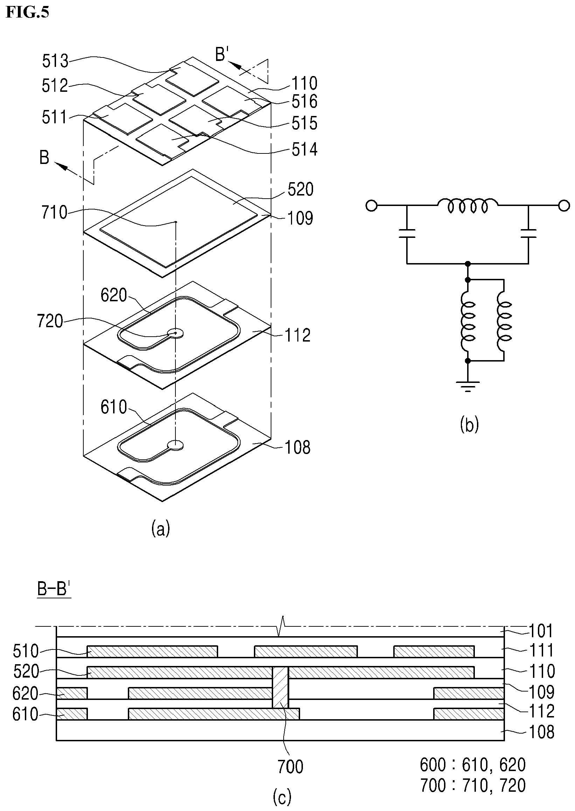

FIGS. 5 to 7 are diagrams illustrating modified examples of the composite element according to the embodiment of the present invention. In FIGS. 5 to 7, (a) and (c) are exploded perspective views and cross-sectional views illustrating a deformed part of the composite element, and (b) is an equivalent circuit diagram of the composite element to which the deformed part is applied. In this case, the equivalent circuit diagram of the composite element is illustrated with a part of the first noise filter portion and a part of the capacitor constituting the second noise filter portion omitted so as to illustrate the deformed part of the composite element.

FIG. 5 is a modified example of the inductor 600 of the second noise filter portion 5000. Referring to (a) and (c) of FIG. 5, the inductors 600 may be respectively formed on two sheets and may be connected to each other by the via electrode 700. For example, a first inductor 610 is formed on the eighth sheet 108, and a second inductor 620 and a hole 720 filled with a conductive material may be formed on the twelfth sheet 112 provided on the upper part of the eighth sheet 108. In (a) of FIG. 5, the first inductor 610 and the second inductor 620 are illustrated as being formed in the same shape, but the first inductor 610 and the second inductor 620 may be formed in different shapes or lengths. The first inductor 610 and the second inductor 620 may be connected to the common electrode 520 through holes 710 and 720 respectively provided on the ninth sheet 109 and the twelfth sheet 112. In this case, the holes 710 and 720 respectively provided on the ninth sheet 109 and the twelfth sheet 112 may form the via electrode 700. In this way, when a plurality of inductors 600 are formed on different sheets and connected to each other by the via electrode 700, since the inductors 600, for example, the first inductor 610 and the second inductor 620, can be formed in different shapes or lengths on each sheet, more diverse inductances can be formed, and, accordingly, the second resonance frequency value can be finely adjusted.

Referring to (b) of FIG. 5, in the stacked device, a first noise coil pattern is provided between the external electrodes 3000 to form the first noise filter portion 2000. Also, two capacitors 500 are provided with the coil pattern in between are provided, and two capacitors 500, and two inductors 600 are provided in parallel between the capacitor 500 and the ground electrode 4000 to form the second noise filter unit 5000. In this way, when two inductors 600 are connected in parallel, implementation of a lower inductance than when there is only one inductor through typical calculation of inductor parallel circuit becomes possible and fine adjustment of the resonance frequency becomes possible, thereby capable of more effectively removing noise in the high frequency band.

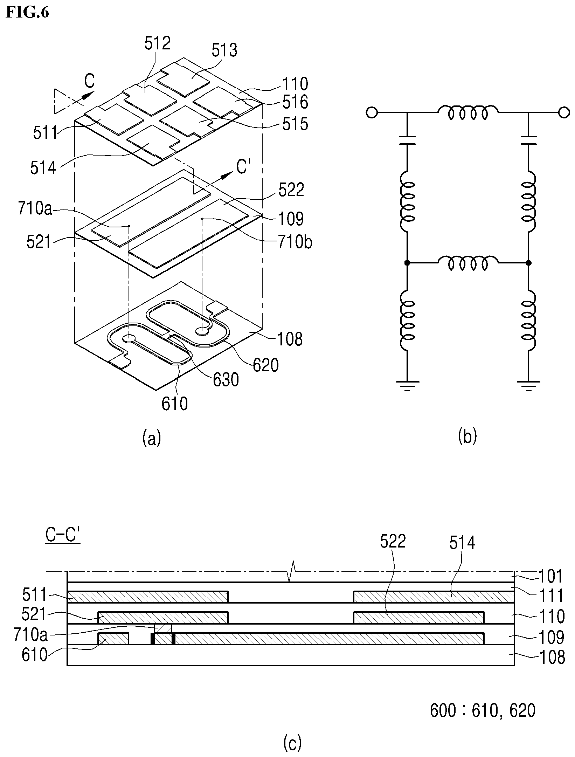

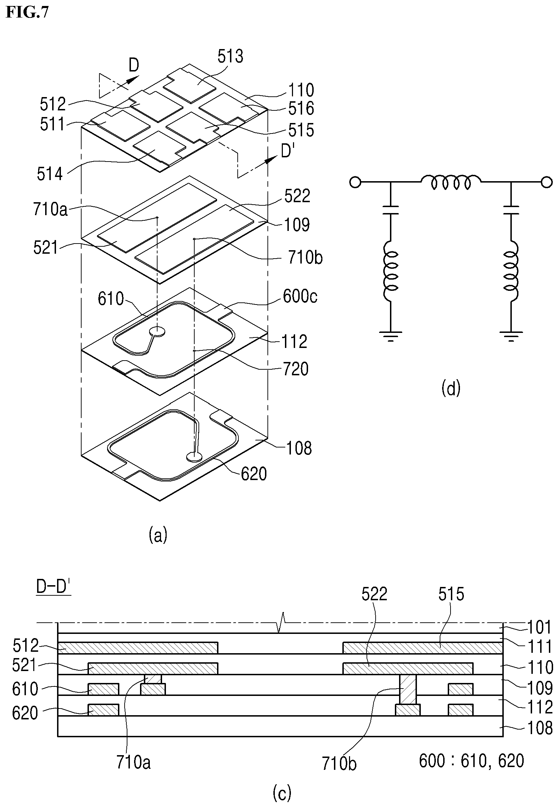

FIGS. 6 and 7 are modified examples of the capacitor 500 and the inductor 600 of the second noise filter portion 5000, and illustrate examples in which two common electrodes 520 of the capacitor 500 are provided, and the inductors 600 are provided equal to the number of common electrodes 520.

First, FIG. 6 illustrates an example in which two common electrodes 520 of the capacitor 500 are provided and two inductors 600 are provided on one sheet. Referring to (a) of FIG. 6 and (c) of FIG. 6, on the ninth sheet 109, a first common electrode 521 overlapping at least a part of the first to third internal electrodes 511 to 513 and a second common electrode 522 overlapping at least a part of the fourth to sixth internal electrodes 514 to 516 may be formed. Also, holes 710a and 710b spaced apart from each other and filled with a conductive material may be formed on the ninth sheet 109. In this case, the holes 710a and 710b may be formed on the first common electrode 521 and the second common electrode 522, and are used as via electrodes 700 for connecting the first and second common electrodes 521 and 522 and the first and second inductors 610 and 620, respectively. On the eighth sheet 108 provided on the lower part the ninth sheet 109, the first inductor 610 located in an area corresponding to the first common electrode 521 and the second inductor 620 located in an area corresponding to the second common electrode 522 may be formed. That is, the first inductor 610 and the second inductor 620 may be formed on one sheet, for example, the eighth sheet 108. Also, the first common electrode 521 and the first inductor 610 may be connected by the hole 710a filled with a conductive material, for example, a first via electrode, and the second common electrode 522 and the second inductor 620 may be connected by the hole 710b filled with a conductive material, for example, a second via electrode. Further, the first inductor 610 and the second inductor 620 may be connected to each other by a horizontal connection wiring 630 and disposed in a parallel structure.

Referring to (b) of FIG. 6, the two inductors 610 and 620 are divided by the connection pattern 630 and each of which functions as two inductors, and the connection pattern 630 acts as another inductor. Accordingly, the second noise filter portion 5000 may have five inductors. For example, in the equivalent circuit diagram of (b) of FIG. 6, the upper left side of the lower part of the capacitor is numbered 1, the upper right side of the lower part of the capacitor is numbered 2, the center is numbered 3, the lower left side is numbered 4, and the lower right side is numbered 5. In this case, LC resonance occurs between inductor number 1 and the capacitor adjacent thereto depending on a device value and LC resonance occurs between inductor number 2 and the capacitor adjacent thereto, and as a result, two LC resonances occur. In this case, when these two LC resonances are overlapped at the same frequency or made to be slightly different, a frequency range corresponding to the specific insertion loss (e.g., -25 dB) of the second resonance frequency generated by the second noise filter portion 5000 can be expanded. As a result, noise can be effectively removed in a wide band.

FIG. 7 illustrates an example in which two common electrodes 520 of the capacitor 500 are provided, and the inductors 600 are respectively provided on two sheets. Referring to (a) of FIG. 7 and (c) of FIG. 7, on the ninth sheet 10, the first common electrode 521 overlapping at least a part of the first to third internal electrodes 511 to 513, and the second common electrode 522 overlapping at least a part of the fourth to sixth internal electrodes 514 to 516 may be formed. Also, the holes 710a and 710b spaced apart from each other and filled with a conductive material may be formed on the ninth sheet 109. On the twelfth sheet 112 provided on the lower part of the ninth sheet 109, the first inductor 610 and the hole 720 filled with a conductive material may be formed. Also, on the eighth sheet 108 provided on the lower part of the twelfth sheet 112, the second inductor 620 may be provided. That is, the first inductor 610 and the second inductor 620 may be respectively formed on different sheets, for example, the twelfth sheet 112 and the eighth sheet 108. The first common electrode 521 and the first inductor 610 may be connected to each other by the hole 710a filled with a conductive material, for example, a first via electrode, and the second common electrode 522 and the second inductor 620 may be connected to each other by the hole 710b filled with a conductive material and the hole 720, which is filled with a conductive material and formed in the twelfth sheet 112, for example, by a second via electrode. Further, the first inductor 610 and the second inductor 620 may be connected to the ground electrode 4000.

Referring to (b) of FIG. 7, in the stacked device, a first noise coil pattern is provided between the external electrodes 3000 to form the first noise filter portion 2000. Also, two capacitors 500 are provided with the coil pattern in between, and two inductors 600 are respectively provided in series between the capacitor 500 and the ground electrode 4000 to form the second noise filter portion 5000. In this way, when two inductors 600 are connected in series, the number of resonance frequencies may be increased by independently controlling the input side LC and the output side LC, or the resonance characteristics can be strengthened by making the resonance frequencies overlap each other.

Here, an example in which two inductors 600 are provided in the stacked body 1000 has been described, but three or more inductors 600 may be provided.

Meanwhile, the composite element according to the embodiment of the present invention can remove noise in a wide frequency band, and can reduce insertion loss caused by the composite element.

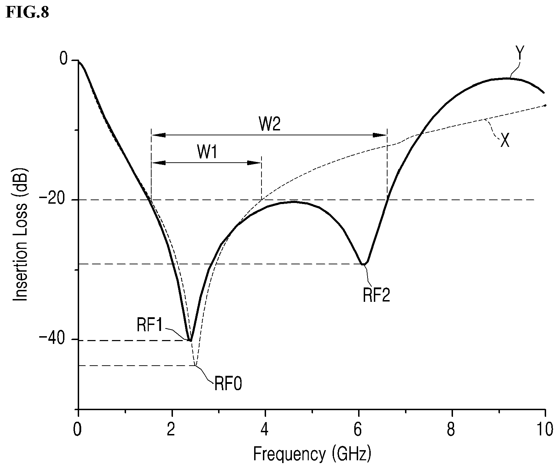

FIG. 8 is a graph of frequency characteristics of the composite element according to the embodiment of the present invention.

Referring to FIG. 8, X is a graph illustrating the frequency characteristics of the composite element according to the prior art, and Y is a graph illustrating the frequency characteristics of the composite element according to the embodiment of the present invention. Here, the composite element according to the prior art may include one type of noise filter portion within the stacked body. Frequencies RFC, RF1, and RF2 that form peaks in the graph are resonance frequencies at which noise can be removed.

For example, if the target insertion loss is set to -20 dB, it was found that the composite element according to the prior art generates a resonance frequency of about 2.5 GHz and has excellent insertion loss characteristics at a bandwidth W1 of about 1.8 to 4 GHz. On the other hand, it was found that the composite element according to the embodiment of the present invention generates a first resonant frequency RF1 of about 2.2 GHz and a second resonant frequency RF2 of about 6 GHz, and has excellent insertion loss characteristics at a bandwidth W2 of about 1.8 to 6.8 GHz. That is, since the composite element according to the prior art removes noise using one type of noise filter portion, it was found out that the composite element according to the prior art generates only one resonance frequency, and the bandwidth of the frequency at which noise can be removed is narrow. However, the composite element according to the embodiment of the present invention generates resonance frequencies in different frequency bands using two types of noise filter portions, that is, the first noise filter portion 2000 and the second noise filter portion 5000, thereby capable of increasing the bandwidth of the frequency at which noise can be removed. Accordingly, the composite element according to the embodiment of the present invention can remove noise in at least two frequency bands, and can therefore be used in the portable electronic device such as a smartphone that employs functions of various frequencies to improve the quality of electronic device.

The present invention is not limited to the embodiments described above, but may be implemented in various different forms. In other words, the embodiment described above is provided to ensure that the disclosure of the present invention is complete and to fully inform those skilled in the art of the scope of the invention, and the scope of the present invention should be understood by the claims of the present application.

### INDUSTRIAL APPLICABILITY

The composite element of the present invention can expand the frequency band at which noise can be removed, and thus noise in a broadband frequency can be removed, and the resonance frequency can be finely adjusted by the interaction between noise filters and thus, the composite element of the present invention can be used in a portable electronic device that use a wide frequency band to improve the quality of the electronic device.

## Claims

1. A composite element comprising:
a stacked body in which a plurality of sheets are stacked;
a plurality of first noise filter portions capable of generating a first resonance frequency and provided in the stacked body, each first noise filter portion including one or more coil patterns;
a second noise filter portion capable of generating a second resonance frequency higher than the first resonance frequency, provided in the stacked body, and including a capacitor and an inductor;
a plurality of external electrodes provided outside the stacked body and connected to the plurality of first noise filter portions and a part of the second noise filter portion; and
a ground electrode provided outside the stacked body and connected to a part of the second noise filter portion.

2. The composite element of claim 1, wherein
the plurality of first noise filter portions comprises at least three or more noise filter portions.

3. The composite element of claim 1, wherein
the coil patterns forming the plurality of first noise filter portions are respectively formed on different sheets, and are disposed to overlap each other in a direction crossing a stacking direction.

4. The composite element of claim 1, wherein
the coil patterns forming the plurality of first noise filter portions are respectively formed on different sheets, and at least one of the coil patterns is disposed to partially overlap or be spaced apart from the remaining coil patterns in a direction crossing a stacking direction.

5. The composite element of claim 1, wherein
the second noise filter portion is formed on a sheet different from the plurality of first noise filter portions.

6. The composite element of claim 5, wherein
the capacitor comprises internal electrodes respectively connected to the plurality of external electrodes and at least one common electrode disposed to overlap the internal electrodes, and the inductor is connected to the ground electrode.

7. The composite element of claim 6, wherein
the capacitor and the inductor are formed on different sheets, and
the second noise filter portion comprises a via electrode for connecting the common electrode and the inductor.

8. The composite element of claim 7, wherein
the second noise filter portion comprises a plurality of inductors formed on different sheets, and
the plurality of inductors are connected to one via electrode.

9. The composite element of claim 7, wherein
the common electrode is provided in plural numbers, and
the via electrode is provided in the same number as the common electrode.

10. The composite element of claim 9, wherein
the second noise filter portion comprises a plurality of inductors formed on one sheet,
each of the plurality of inductors is connected to a different via electrode, and
the plurality of inductors are connected to each other by a horizontal connection wiring.

11. The composite element of claim 9, wherein
the second noise filter portion comprises a plurality of inductors formed on different sheets, and
each of the plurality of inductors is connected to a different via electrode.

12. The composite element of any one of claims 1 to 11, wherein
a width between the first resonance frequency and the second resonance frequency is adjusted by at least one of a capacitance of the capacitor and an inductance of the inductor, and an impedance formed between the coil patterns.
